# EUROPEAN PATENT SPECIFICATION

(11) **EP 2 561 931 B1**
(45) Date of publication and mention of the grant of the patent: **17.06.2020**
(21) Application number: 12180285.4
(22) Date of filing: 13.08.2012
(51) Int. Cl.: B05C 5/02, B05C 11/10

(54) **Pneumatically-driven jetting valves with variable drive pin velocity, improved jetting systems and improved jetting methods**
Pneumatisch angetriebene Spritzventile mit variabler Antriebsstiftgeschwindigkeit, verbesserte Spritzsysteme und verbesserte Spritzverfahren
Soupapes d'injection pneumatiques avec vitesse d'arbre d'entraînement variable, systèmes d'injection améliorée et procédés d'injection améliorée

(30) Priority: 26.08.2011 US 201113219070
(43) Date of publication of application: 27.02.2013
(73) Proprietor: Nordson Corporation, Westlake, OH 44145 (US)
(72) Inventor: Ahmadi, Mani, Oceanside, CA California 92057 (US); Fiske, Erik, Carlsbad, CA California 92008 (US); Maiorca, Philip Paul, Poway, CA California 92064 (US); Quinones, Horatio, San Marcos, CA California 92078 (US); Wright, Robert James, Carlsbad, CA California 92010 (US)
(74) Representative: Findlay, Alice Rosemary

(56) References cited:
- WO-A1-2008/124770
- WO-A1-2011/071888
- WO-A1-2011/087960
- US-A- 4 763 560
- US-A1- 2004 134 996

## Description

The invention relates generally to the jetting of fluid materials and, in particular, to electro-pneumatic jetting valves, jetting systems and improved jetting methods.

Jetting valves are used in the electronic packaging assembly to jet minute dots of a fluid material onto a substrate. Numerous applications exist for jetting valves that jet fluid materials such as underfill materials, encapsulation materials, surface mount adhesives, solder pastes, conductive adhesives, and solder mask materials, fluxes, and thermal compounds. As the type of fluid material changes, the jetting valve must be adapted to match the fluid material change. A "jetting valve" or "jetting device" is a device which ejects, or "jets", a droplet of material from the dispenser to land on a substrate, wherein the droplet disengages from the dispenser nozzle before making contact with the substrate. Thus, in a jetting type dispenser, the droplet dispensed is "in-flight" between the dispenser and the substrate, and not in contact with either the dispenser or the substrate, for at least a part of the distance between the dispenser and the substrate.

Materials that can be jetted by means of jetting valves can have different characteristics, such as viscosity, elasticity, etc. As the characteristics change, different needle velocities are required to promote proper jetting from the jetting valve. Needle velocity affects key characteristics of the jetted fluid material, such as proper break-off, dot velocity, and satellite generation. In general, thicker, higher viscosity materials require a higher needle velocity to be jetted than thinner, lower viscosity materials.

Jetting valves may be electro-pneumatically actuated using a pneumatic piston that moves a needle used to jet the fluid material as the needle strikes a valve seat. An example of one such jetting valve is described in WO 2008/124770. The jetting valve of WO 2008/124770 comprises a piston arranged between a first and second air chambers connected via respective air inlets to a source of pressurized air, a valve shaft extending through a central bore in the piston, and a solenoid valve arranged between the source of pressurized air and the air chambers. The solenoid valve is actuated by a controller to exhaust the first air chamber while concurrently pressurizing the second air chamber, when closing the valve, and conversely, to exhaust the second air chamber while concurrently pressurizing the first air chamber, when opening the valve. In conventional designs for electro-pneumatic jetting valves, a single solenoid valve is used to port air pressure to the pneumatic piston to open the jetting valve and a return spring is used to close the jetting valve at a fast enough speed to jet a droplet of material. As a result, the velocity of the needle, or drive pin, is not highly variable and generally remains within a relatively narrow range. Given that the needle velocity is limited to a relatively narrow range, the range of material viscosities that can be jetted is likewise limited in such jetting devices.

US 4763560 relates to a method and apparatus for rapidly and accurately driving and positioning a fluid actuator. The fluid actuator comprises a cylinder and a piston reciprocated within the cylinder, the piston being arranged between a first and second air chambers. Four on-off control valves are provided for connecting and disconnecting the first and second air chambers with a source of pressurized air. When all four valves are closed and a first one is opened, pressurized air is supplied into the first air chamber and the piston is moved in a first direction when the fourth valve is opened. If only the second valve is opened, pressurized air is supplied into the second air chamber and the piston is moved in a second direction opposite the first direction when the third valve is opened. Further, opening of the third valve connects the first air chamber with the outer environment to vent the first air chamber, while opening of the fourth valve connects the second air chamber with the outer environment to vent the second air chamber.

While conventional jetting valves have proven adequate for certain applications, improved jetting valves are needed with a higher capability for adapting to different fluid material characteristics.

According to the present invention there is provided a jetting valve as defined in the accompanying claims.

In one embodiment, a jetting valve is provided for use with a supply of fluid material and a supply of air pressure. The jetting valve includes a pneumatic actuator having a pneumatic piston and a drive pin extending from the pneumatic piston. The jetting valve further includes a housing having a first chamber and a second chamber. The pneumatic piston is enclosed between the first and second chambers, and the drive pin is moved by the pneumatic piston. First and second solenoid valves are connected to the supply of air pressure. The first solenoid valve has a first state in which air pressure is supplied to the first chamber to apply a first force to the pneumatic piston for moving the pneumatic piston and drive pin in a first direction. The first solenoid valve has a second state in which the first air chamber is vented to ambient pressure. The second solenoid valve has a first state in which air pressure is supplied to the second chamber to apply a second force to the pneumatic piston for moving the pneumatic piston and drive pin in a second direction. The second solenoid valve has a second state in which the second air chamber is vented to ambient pressure.

The jetting valve further includes a fluid chamber and a nozzle. The fluid chamber encloses a valve seat and a valve element. The nozzle has a dispense orifice and a flow passage in fluid communication with the valve seat. The valve element is movable to a position in contact with the valve seat to jet a droplet of material from the dispense orifice.

A controller of the jetting valve is configured to hold the first solenoid valve in the first state for a first time period and the second solenoid valve in the first state for a second time period, where the beginning of the second time period follows the beginning of the first time period. The drive pin is moved towards the valve seat during the second time period, and the movement of the drive pin during the second time period causes the valve element to move into contact with the valve seat to jet a droplet of material. The controller maintains a predetermined overlap period between said first time period and said second time period. The overlap period is used to control the speed of the drive pin as the drive pin is moved towards the valve seat during the second time period, which in turn, controls the speed of the valve element as it contact with the valve seat. The faster the drive pin is moved, the faster the valve element moves.

The jetting valve may further include a fluid module containing the fluid chamber. The movement of the drive pin during the second time period causes the drive pin to contact the fluid module, and the contact of the drive pin with the fluid module causes the valve element to move into contact with the valve seat. The jetting valve may further include a resilient member in the fluid module, the resilient member configured to bias the valve element away from the valve seat.

The housing of the jetting valve may include a spring that exerts a spring bias on the pneumatic piston. The spring may be compressed when the pneumatic piston is moved in the first direction by compressed air supplied to the first chamber, and the spring may be expanded when the pneumatic piston is moved in the second direction by compressed air supplied to the second chamber.

Each movement of the valve element jetting valve into contact with the valve seat may operate to jet a droplet of material through the nozzle orifice.

### Systems Having User Interface To Control Valve Speed Of A Pneumatic Jetting Device

In another embodiment, a system for jetting is provided that includes a jetting device having a pneumatic piston that causes movement of a valve element that contacts a valve seat to jet a droplet of material and a controller having a user interface that enables the user to vary the speed of the valve element.

The jetting device can have upper and lower piston chambers on opposite sides of the piston that are controlled by independent solenoid valves, wherein the speed of the valve element is controlled by the control of the solenoids.

In another embodiment, the solenoids can be controlled to provide a desired overlap time period during which compressed air is supplied to both the upper and lower piston chambers at the same time to control the speed of the valve element.

### Methods for Jetting From A Pneumatically Actuated Jetting Device Having A Valve Speed User Interface

In one method, the jetting device has pneumatically driven piston that causes a valve element to move into contact with a valve seat to jet a droplet of material, and a user interface is provided that the user can use to input information that is used by the controller to vary the speed of the valve element.

The jetting device can have upper and lower piston chambers on opposite sides of the piston that are controlled by independent solenoid valves, wherein the speed of the valve element is controlled by the control of the solenoids.

Various other methods are described below that will not be reiterated here to avoid unnecessary duplication.

The invention will now be further described by way of example with reference to the accompanying drawings, which are incorporated in and constitute a part of this specification, illustrate exemplary embodiments of the invention and, together with a general description of embodiments of the invention given above, and the detailed description given below, serve to explain the principles of the embodiments of the invention.
FIG. 1A is a perspective view of a jetting valve in accordance with an embodiment of the invention.
FIG. 1B is a perspective view similar to FIG. 1A in which an outer housing of the modular jetting device has been removed for purposes of description.
FIG. 2 is a cross-sectional view taken generally along line 2-2 in FIG. 1B, but showing only the heater, fluid module and piston housing, and functional blocks representing the components for supplying compressed air to the piston chambers.
FIG. 3 is a diagrammatic view of the hydraulic circuit of the jetting valve of FIGS. 1 and 2.
FIG. 4 is a diagrammatic view of the control signals for the solenoid valves used to operate the electro-pneumatic jetting valve of FIGS. 1-3 in accordance with an embodiment of the invention.
FIG. 5 is a diagrammatic view similar to FIG. 4 in which the timing of the control signals for the solenoid valves is modified so that the overlap time over which air pressure is applied to the air chambers is reduced in comparison with FIG. 4.
FIG. 6 is a graph of overlap time versus viscosity.

Subheadings are provided in some sections below to help guide the reader through some of the various embodiments, features and components of the invention.

Generally, the embodiments of the invention relate to a jetting valve that uses first and second solenoid valves to operate a pneumatic piston of an electro-pneumatic actuator, which precipitates movement of a valve element for opening and closing the jetting valve. Independent air lines are coupled with top and bottom chambers of the pneumatic piston. The first and second solenoid valves independently control the air pressure supplied to the top and bottom chambers of a pneumatic piston. The first solenoid valve is used to open the jetting valve and the second solenoid valve is used to close the jetting valve. The velocity of the needle that is fixed to the piston to cause the valve to open and close can be varied by changing the amount of time that the action of the second solenoid valve in supplying compressed air to the top piston chamber overlaps with the action of the first solenoid valve in supplying compressed air to the bottom piston chamber. By controlling the amount of overlap in the electric pulses controlling these first and second solenoid valves, the operator can control the needle velocity, and thereby select, or produce, an optimum needle velocity for the fluid material being jetted, based its fluid material characteristics.

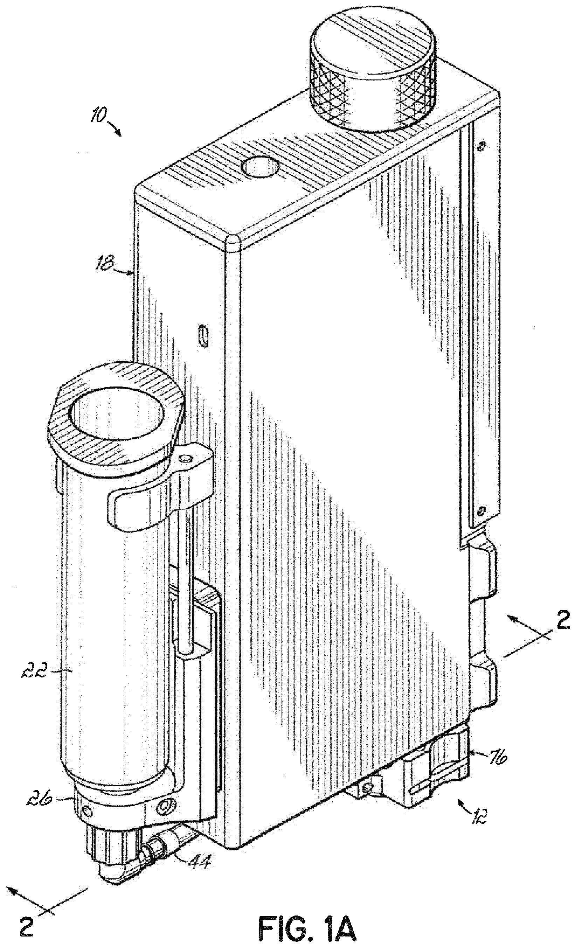

With reference to FIGS. 1A-3 and in accordance with an embodiment of the invention, a jetting valve 10 includes a fluid module 12 that has a valve element 14, an electro-pneumatic actuator 16, an outer cover 18, and a fluid interface 20. The outer cover 18 is composed of thin sheet metal and is fastened to the inner framework of the jetting valve 10 by conventional fasteners. The jetting valve 10 includes a syringe holder 26 mounted as an appendage to the outer cover 18. A syringe 22 is supported by the syringe holder 26 and the jetting valve 10 is supplied with pressurized fluid material from the syringe 22. Generally, the fluid material may be any material or substance known by a person having ordinary skill in the art to be amenable to jetting and may include, but is not limited to, solder flux, solder paste, adhesives, solder mask, thermal compounds, oil, encapsulants, potting compounds, inks and silicones. When the fluid material in the syringe 22 is depleted or changed, the syringe 22 is removed from the syringe holder 26 and replaced.

The jetting valve 10 may be installed on a robot, for example, in a machine or system (not shown) for intermittently jetting amounts of a fluid material as dots onto a substrate, such as a printed circuit board. The jetting valve 10 may be operated such that a succession of jetted amounts of the fluid material are deposited on the substrate as a line of spaced-apart dots. The substrate targeted by the jetting valve 10 may support various surface mounted components, which necessitates jetting the minute amounts of fluid material rapidly and with accurate placement to deposit fluid material at targeted locations on the substrate.

### Fluid Module

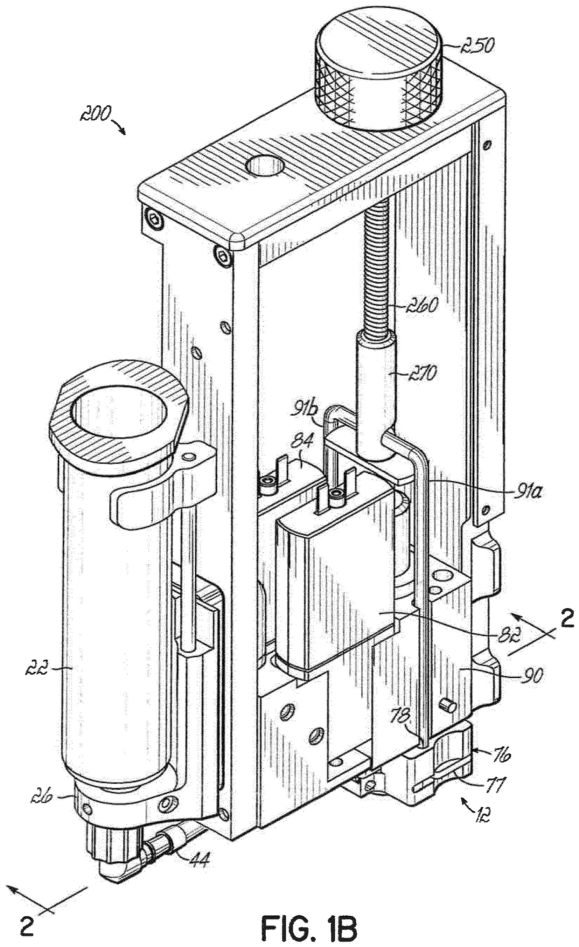

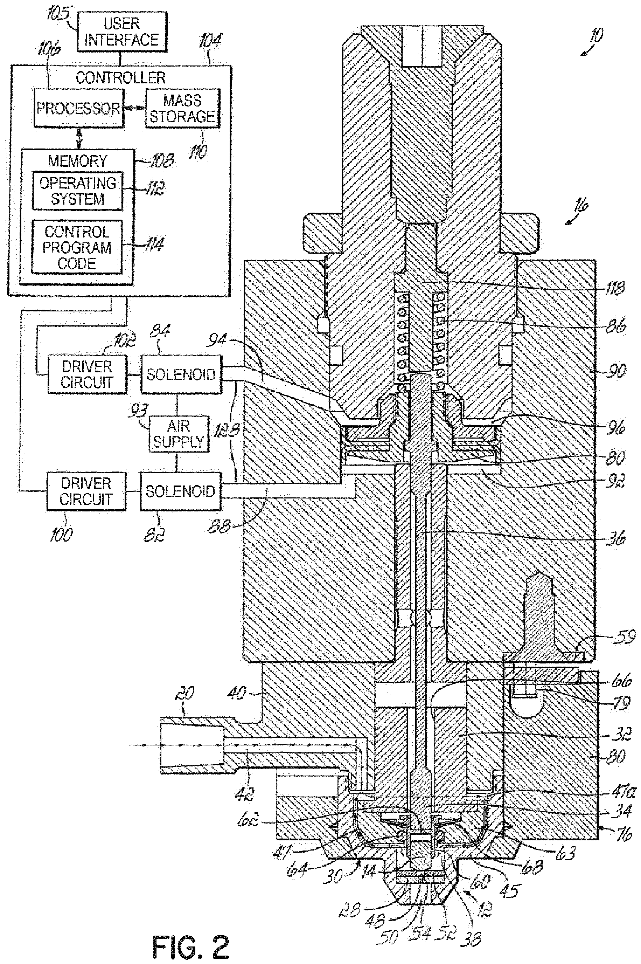

As best visible in FIG. 2, the fluid module 12 may include a nozzle 28, a module body 30, and a fluid chamber 38 in communication with the fluid connection interface 20. A first section or portion 40 of the module body 30 includes a fluid passageway 42 that couples the fluid interface 20 in fluid communication with the fluid chamber 38 through passageways 47, 47a (later described). A fluid conduit 44 (FIG. 1B) extends from the syringe 22 to the fluid interface 20 for placing the fluid module 12 in fluid communication with the fluid material contained inside the syringe 22 and for supplying the fluid material under pressure from the syringe 22 to the fluid connection interface 20. In this embodiment, the fluid conduit 44 is typically a length of tubing directly connecting the outlet of the syringe 22 with the fluid connection interface 20 without any intervening structure. In one embodiment, the fluid connection interface 20 includes a Luer fitting.

The syringe 22 may be configured to use pressurized air to direct the fluid material to flow toward the fluid interface 20 and ultimately to the fluid chamber 38 of the fluid module 12. The pressure of the pressurized air, which is supplied to the head space above the fluid material contained in the syringe 22, may range from forty (40) psig to sixty (60) psig. Typically, a wiper or plunger (not shown) is disposed between the air pressure in the head space and the fluid material level inside the syringe 22, and a sealing cap (not shown) is secured to the open end of the syringe barrel for supplying the air pressure.

A second portion 45 of the module body 30 is configured to support the nozzle 28. A valve seat 52 is disposed between the fluid inlet 42 and the fluid chamber 38. The valve seat 52 has an opening 54 in fluid communication with the fluid outlet 48.

The fluid module 12 may further include a strike plate in the form of a wall 62 of a movable element 60. A biasing element 68, which peripherally contacts the movable element 60, is configured to apply an axial spring force to the movable element 60.

A sealing ring 64 supplies a sealing engagement between an insert 63 and the exterior of the movable element 60. The part of the moveable element 60 which is below sealing ring, or O-ring, 64 defines a part of the boundary of the fluid chamber 38. The valve element 14 is attached to moveable element 60 and is located inside the fluid chamber 38 at a location between the wall 62 of the movable element 60 and the valve seat 52. Alternately, valve element 14 and movable element 60 may be constructed as a single unitary element, rather than two separate elements.

A third portion 32 of the module body is attached to the top of insert 63 by a friction fit. The second portion 45 of the module body is attached by a friction fit to the first portion 40 of the module body to enclose all the other components of the fluid module. Namely, once first portion 40 and second portion 45 are pressed together they enclose these parts of the fluid module: nozzle 28, valve seat 52, valve element 14, movable element 60, sealing ring 64, biasing element 68, insert 63 and third portion 32 of the module body. Thus, in the preferred embodiment, the fluid module is comprised of elements 45, 40, 28, 52, 14, 60, 64, 68, 63 and 32. As an alternative to using friction fits, threaded connections could be used to allow these components to be more easily disassembled.

In the assembled position described above and shown in Figure 2, the passageways 47 and 47a that couple the fluid passage 42 in fluid communication with the fluid chamber 38 are provided as follows. Annular passageway 47a is created by a space provided between first portion 40 and third portion 32 of module body 30. Passageway 47 is provided by grooves or channels formed on the outside of insert 63. When insert 63 is press fit into second portion 45 of the module body 30, the grooves on the exterior of insert 63 and the interior surface of second portion form passageways 47. If insert 63 were threaded into second portion 45, instead of being press fit into it, a fluid passageway could be drilled through the insert 63 provide a flow path from fluid passage 42 to fluid chamber 38.

### Syringe

As described above, a fluid conduit 44 (FIG. 1) extends from the syringe 22 to the fluid interface 20 for placing the fluid module 12 in fluid communication with the fluid contained inside the syringe 22 and for supplying the fluid material under pressure from the syringe 22 to the fluid interface 20. The fluid conduit 44 may be a length of tubing directly connecting the syringe 22 and fluid interface 20 without any intervening structure. Fluid material is fed through the passageway 42 to the fluid chamber 38 and, as fluid material is dispensed by the jetting valve 10, the arriving fluid material from the syringe 22 replenishes the fluid material volume in the fluid chamber 38.

The syringe 22 is configured to use pressurized air to direct the fluid material to the passageway 42 and ultimately through a passageway 47 in the fluid module 12 to the fluid chamber 38. The pressurized air, which is confined by a wiper or plunger (not shown) in a headspace above the fluid material contained in the syringe 22, may range from five (5) psig to sixty (60) psig.

### Drive Pin

A drive pin 36 is indirectly coupled with the valve element 14 to jointly cooperate with fluid module 12 to jet fluid material from the jetting valve 10. The tip 34 of the drive pin 36 operates in a hammer-like manner to transfer its momentum in an impulse to the wall 62 of the movable element 60. The valve element 14 is disposed inside the fluid chamber 38 on the opposite side of the wall 62 of the movable element 60 from the tip 34 of the drive pin 36. The impact of the tip 34 of the actuated drive pin 36 with the wall 62 of the movable element 60 causes the valve element 14 to impact the valve seat 52 and jet fluid material from the fluid chamber 38. The faster the drive pin 36 is moving when it strikes the wall 62, the faster the valve element 14 will move to impact the valve seat 52 and jet a droplet of material. Consequently, by controlling the speed of the drive pin 36 in the manner described below, the speed of the valve element 14 is also controlled. As described above, biasing element 68 is in contact with the movable element 60 to apply an axial spring force to the movable element 60. When the drive pin 36 is not pushing down on the wall 62, the valve element 14 and movable element 60 are moved away from the valve seat 52 by the axial spring force applied by the biasing element 68. As mentioned above, the movable element 60 and the valve element 14 may be constructed as a single, unitary component, rather than as two separate components.

### Heater

A heater 76, which has a body 80 that operates as a heat transfer member, at least partially surrounds the fluid module 12. The heater 76 may include a conventional heating element (not shown), such as a cartridge-style resistance heating element residing in a bore defined in the body 80. The heater 76 may also be equipped with a conventional temperature sensor (not shown), such as a resistive thermal device (RTD), a thermistor, or a thermocouple, providing a feedback signal for use by a temperature controller in regulating the power supplied to the heater 76. The heater 76 includes spring-loaded pins 79 that contact respective contacts 59 in the piston housing 90 in order to provide signal paths for a temperature sensor and to provide current paths for transferring electrical power to the heating element and temperature sensor.

As best seen in Figure 2, the fluid module 12 sits within the heater 76. With reference to Figure 1B, arms 91a and 91b include lower ends that are received within the holes 78 of heater 76 and are releasably secured within the heater 76 by spring biased clips 77 that are received within slots (not shown) in the arms 91a, 91b. As the knob 250 is rotated, the bolt 260 that is fixed to knob 250 rotates within a threaded collar 270 that is fixed to the arms 91a and 91b. Thus, knob 250 is rotated until the heater 76 and fluid module 12 are brought up into compressive contact with the piston body 90.

To remove the fluid module 12 and heater 76, the knob 250 is rotated in the reverse direction to lower the fluid module 12 and heater 76 away from piston body 90. The spring biased clips 77 are then depressed to withdraw the clips from the slots in arms 91a, 91b, so that the fluid module 12 and heater 76 can be detached from the jetting valve 10. To reattach fluid module 12 and heater 76, the lower ends of arms91a, 91b are inserted into the holes 78 in heater 76 until the latches 77 snap into the slots in the arms 91a, 91b. The knob 250 is then rotated until heater 76 and fluid module 12 are brought into contact with piston body 90.

### Opposing Piston Air Chambers with Independent Solenoids

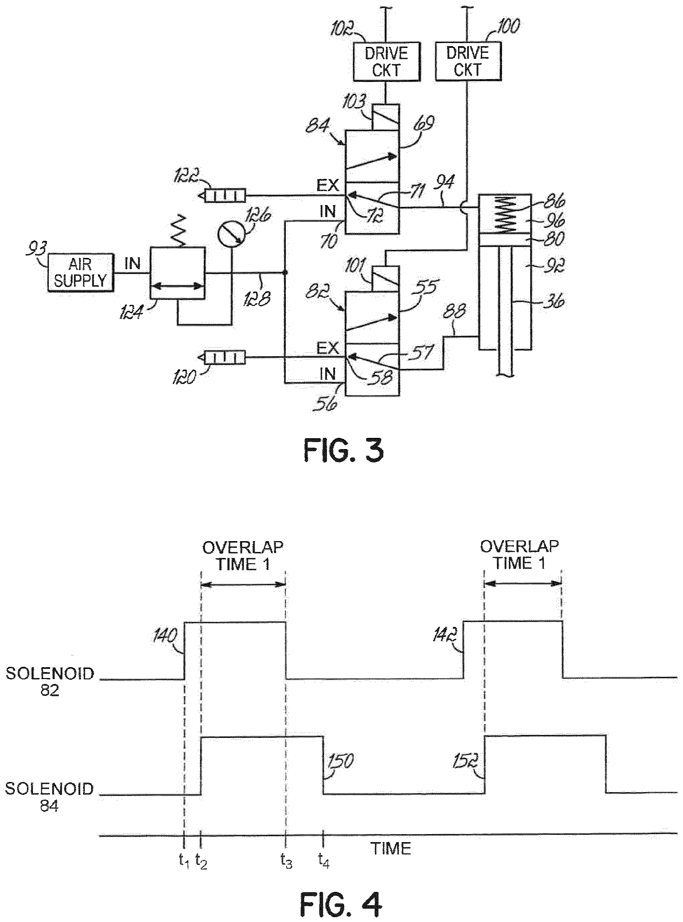

With reference to FIGS. 2 and 3, the electro-pneumatic actuator 16 of the jetting valve 10 includes the drive pin 36 and a pneumatic piston 80 affixed to one end of the drive pin 36. A pair of air piston chambers 92, 96 are defined inside a piston housing 90 of the jetting valve 10 and separated from each other by the pneumatic piston 80. The volume of each of the air chambers 92, 96 can vary according to the position of the pneumatic piston 80. A compression spring 86 is captured between a spring retainer 118 and the pneumatic piston 80. The force applied by the compression spring 86 operates as a closure force that acts on the pneumatic piston 80 and drive pin 36 to bias the drive pin 36 toward the wall 62 of the movable element 60. Thus, when both piston chambers 92, 96 are vented to atmosphere, the spring 86 bias drive pin 36 against the wall 62, which in turn, biases the valve element 14 against the valve seat 52, to maintain the jetting valve 10 in the normally closed position.

The jetting valve 10 includes solenoid valves 82, 84, which are electro-mechanical devices used to control the flow of air pressure from an air supply 93 to the air chambers 92, 96. Air chamber 92 is disposed on one side of the pneumatic piston 80 and air chamber 96 is disposed on the opposite side of the pneumatic piston 80 from air chamber 92. As the pneumatic piston 80 moves in response to selective pressurization of the air chambers 92, 96, the volume of each of the air chambers 92, 96 will change.

The first solenoid valve 82 is coupled by a first passageway 88 penetrating the housing 90 of the jetting valve 10 with the air chamber 92 on one side of the pneumatic piston 80. As shown in Figure 3, the first solenoid valve 82 includes a mechanical valve 55 with an air inlet port 56, an air exhaust port 58, and a flow path 57 that can be switched to be coupled with either the air inlet port 56 or the air exhaust port 58. The first solenoid valve 82 is configured to either port air pressure from the air supply 93 through the air inlet port 56 and first passageway 88 to the air chamber 92 or to exhaust air pressure from the air chamber 92 through the first passageway 88 and air exhaust port 58. The air pressure pressurizing air chamber 92 acts on the surface area of the pneumatic piston 80 sharing a boundary with the air chamber 92 to apply a force to the pneumatic piston 80 and the drive pin 36 connected to the pneumatic piston 80 to move drive pin 36 in a direction away from the fluid module 12.

The second solenoid valve 84 is coupled by a second passageway 94 penetrating the housing 90 of the jetting valve 10 with the air chamber 96. The second solenoid valve 84 includes a mechanical valve 69 with an air inlet port 70, an air exhaust port 72, and a flow path 71 that can be switched to be coupled with either the air inlet port 70 or the air exhaust port 72. The second solenoid valve 84 is configured to either port air pressure from the air supply 93 through the air inlet port 70 and second passageway 94 to the air chamber 96 or to exhaust air pressure from the air chamber 96 through the second passageway 94 and air exhaust port 72. The air pressure pressurizing air chamber 96 acts on the surface area of the pneumatic piston 80 sharing a boundary with the air chamber 96 to apply a force to the pneumatic piston 80 and the drive pin 36 connected to the pneumatic piston 80, that is opposite in direction to the force applied by air pressure inside air chamber 92, to move drive pin 36 in a direction towards fluid module 12.

The exhaust of solenoid valve 82 is fitted with a silencer 120 and the exhaust of solenoid valve 84 is also fitted with a silencer 122. The silencers 120, 122 reduce the level of noise produced by the exhaust of pressurized air from the solenoid valves 82, 84. The pressure of the compressed air from the air supply 93 is regulated by a regulator 124 before being supplied to the solenoid valves 82, 84. An air line 128 branches to supply regulated air pressure from the regulator 124 to the air inlet ports 56, 70 on the inlet side of the solenoid valves 82, 84. The regulator 124 is used to set the air pressure on the inlet side of the solenoid valves 82, 84. The pressure at the outlet of the regulator 124 and on the inlet side of the solenoid valves 82, 84 is displayed on a pneumatic pressure gauge 126.

The solenoid valves 82, 84 also include respective solenoids 101, 103 with coils that are electrically actuated by respective driver circuits 100, 102. The driver circuits 100, 102 are coupled in communication with a controller 104, which provides independent supervisory control over the driver circuits 100, 102. The driver circuits 100, 102 are of a known design with a power switching circuit providing electrical signals to the solenoids 101, 103, respectively.

### Controller

The controller 104 can cause the driver circuit 100 to supply an electrical signal as a current pulse of a given duration to the solenoid 101 of solenoid valve 82. In response to the electrical signal, the current flowing through the coil of the solenoid 101 generates a magnetic field that causes the displacement of an actuator mechanically linked to the mechanical valve 55 of solenoid valve 82. The mechanical valve 55 then changes state by opening the flow path 57 so that the first passageway 88 is coupled by the air inlet port 56 and flow path 57 with the air supply 93. Pressurized air flows from the air supply 93 through the first passageway 88 into the air chamber 92, which is a closed variable volume that is pressurized by the arriving air pressure, to put an upward pressure on the piston 80 in Figure 2.

When the electrical signal to the coil of solenoid 101 is discontinued, a spring (not shown) is used to return the actuator and mechanical valve 55 back to an idle state. In the idle state, the solenoid valve 82 switches the flow path 57 of the mechanical valve 55 so that the air exhaust port 58 of solenoid valve 82 is coupled with the first passageway 88. Air pressure is exhausted or vented from air chamber 92 through the first passageway 88, flow path 57, and air exhaust port 58. Thus, solenoid 101, unless energized, is set to vent the chamber 92. If the pneumatic piston 80 is moved downwardly in Figure 2 to reduce the open volume of air chamber 92, air in air chamber 92 can vent through the air exhaust port 58. The air chamber 92 may be de-pressurized by the venting process and/or may be maintained at or near atmospheric pressure (i.e., ambient pressure) by the venting process.

Similarly, the controller 104 can cause the driver circuit 102 to supply an electrical signal as a current pulse of a given duration to the solenoid 103 of solenoid valve 84. In response to the electrical signal, the current flowing through the coil of the solenoid 103 generates a magnetic field that causes the displacement of an actuator mechanically linked to the mechanical valve 69 of solenoid valve 84. The mechanical valve 69 then changes state by opening the flow path 71 so that the second passageway 94 is coupled by the air inlet port 70 and flow path 71 with the air supply 93. Pressurized air flows from the air supply 93 through the second passageway 94 into the air chamber 96, which is another closed variable volume that is pressurized by the arriving air pressure, to put a downward pressure on the piston 80 in Figure 2.

When the electrical signal to the coil of solenoid 103 is discontinued, a spring (not shown) is used to return the actuator and mechanical valve 69 back to an idle state. In the idle state, the solenoid valve 84 switches the flow path 71 of the mechanical valve 69 so that the air exhaust port 72 of solenoid valve 84 is coupled with the second passageway 94. Air pressure is exhausted or vented from air chamber 96 through the second passageway 94, flow path 71, and air exhaust port 72. Thus, solenoid 103, unless energized, is set to vent the chamber 92. If the pneumatic piston 80 is moved upwardly in Figure 2 to reduce the open volume of air chamber 96, air in air chamber 96 can vent through the air exhaust port 72. The air chamber 96 may be de-pressurized by the venting process and/or may be maintained at or near atmospheric pressure (i.e., ambient pressure) by the venting process.

The operation of the solenoid valves 82, 84 to open and close the mechanical valves 55, 69 may be coordinated to open and close the jetting valve 10 for controlling the jetting fluid material from the fluid module 12. Specifically, motion of the pneumatic piston 80 caused by the selective pressurization of air chambers 92, 96 moves the tip 34 of the drive pin 36 relative to the wall 62 of the movable element 60 of fluid module 12 to move the valve element 14 towards and away from valve seat 52 to jet droplets of material.

The controller 104 may send one control signal to the driver circuit 100 associated with solenoid valve 82 to cause air chamber 92 to be pressurized and another separate control signal to the driver circuit 102 associated with solenoid valve 84 to cause air chamber 96 to be pressurized. As described below, the timing of the control signals may be selected to control the speed of the drive pin 36, and in turn, the speed at which valve element 14 drives valve seat 52 to jet a droplet of material.

The controller 104 may comprise any electrical control apparatus configured to control one or more variables based upon one or more user inputs. Those user inputs can be provided by the user through a user interface 105 that can be a key board, mouse and display, or touch screen, for example. The controller 104 can be implemented using at least one processor 106 selected from microprocessors, micro-controllers, microcomputers, digital signal processors, central processing units, field programmable gate arrays, programmable logic devices, state machines, logic circuits, analog circuits, digital circuits, and/or any other devices that manipulate signals (analog and/or digital) based on operational instructions that are stored in a memory 108. The memory 108 may be a single memory device or a plurality of memory devices including but not limited to random access memory (RAM), volatile memory, nonvolatile memory, static random access memory (SRAM), dynamic random access memory (DRAM), flash memory, cache memory, and/or any other device capable of storing digital information. The controller 104 has a mass storage device 110 that may include one or more hard disk drives, floppy or other removable disk drives, direct access storage devices (DASD), optical drives (e.g., a CD drive, a DVD drive, etc.), and/or tape drives, among others.

The processor 106 of the controller 104 operates under the control of an operating system 112, and executes or otherwise relies upon computer program code embodied in various computer software applications, components, programs, objects, modules, data structures, etc. The computer program code residing in memory 108 and stored in the mass storage device 110 also includes control program code 114 that, when executing on the processor 106, provides control signals as current pulses to the driver circuits 100, 102 for driving the solenoid valves 82, 84. The computer program code typically comprises one or more instructions, whether implemented as part of an operating system or a specific application, component, program, object, module or sequence of operations, that are resident at various times in memory 108, and that, when read and executed by the processor 106, causes the controller 104 to perform the steps necessary to execute steps or elements embodying the various embodiments and aspects of the invention. The routines executed to implement the embodiments of the invention executed by one or more specific or general purpose controllers of the control system will be referred to herein as "computer program code" or simply "program code."

Various program code described herein may be identified based upon the application within which it is implemented in a specific embodiment of the invention. However, it should be appreciated that any particular program nomenclature that follows is used merely for convenience, and thus the invention should not be limited to use solely in any specific application identified and/or implied by such nomenclature. Furthermore, given the typically endless number of manners in which computer programs may be organized into routines, procedures, methods, modules, objects, and the like, as well as the various manners in which program functionality may be allocated among various software layers that are resident within a typical computer (e.g., operating systems, libraries, API's, applications, applets, etc.), it should be appreciated that the invention is not limited to the specific organization and allocation of program functionality described herein.

As will be appreciated by one skilled in the art, the embodiments of the invention may also be embodied in a computer program product embodied in at least one computer readable storage medium having non-transitory computer readable program code embodied thereon. The computer readable storage medium may be an electronic, magnetic, optical, electromagnetic, infrared, or semiconductor system, apparatus, or device, or any suitable combination thereof, that can contain, or store a program for use by or in connection with an instruction execution system, apparatus, or device. Exemplary computer readable storage medium include, but are not limited to, a hard disk, a floppy disk, a random access memory, a read-only memory, an erasable programmable read-only memory, a flash memory, a portable compact disc read-only memory, an optical storage device, a magnetic storage device, or any suitable combination thereof. Computer program code containing instructions for directing a processor to function in a particular manner to carry out operations for the embodiments of the present invention may be written in one or more object oriented and procedural programming languages. The computer program code may supplied from the computer readable storage medium to the processor of any type of computer, such as the processor 106 of the controller 104, to produce a machine with a processor that executes the instructions to implement the functions/acts of a computer implemented process for sensor data collection specified herein.

### Control of Overlap Time

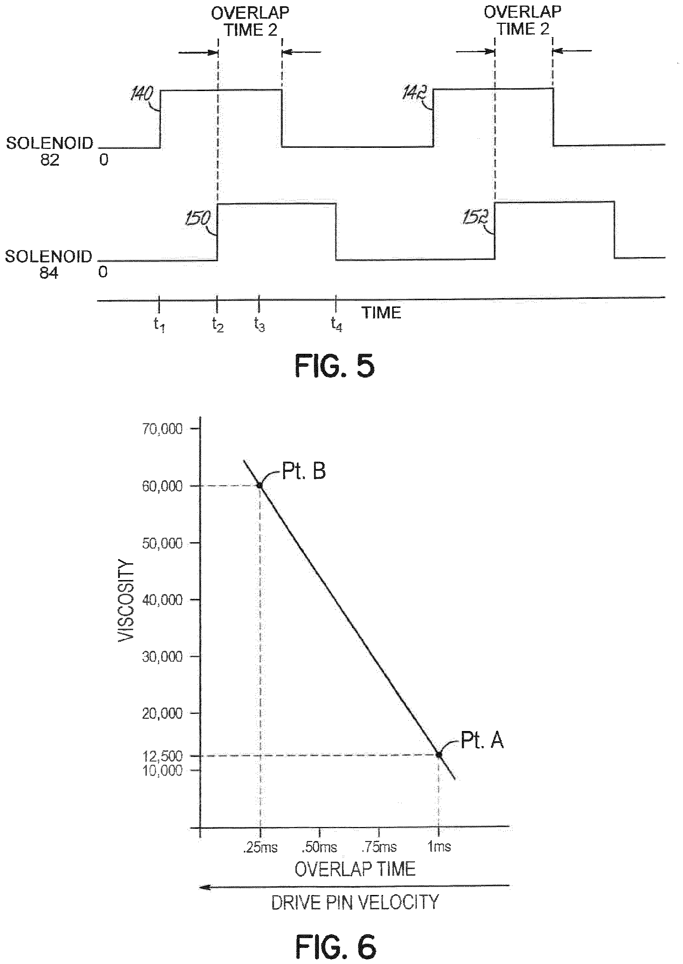

FIGS. 4 and 5 show electric pulse signals supplied as drive currents to the respective solenoids 101, 103 of solenoid valves 82, 84 to open the solenoid valves 82, 84 and supply pressurized air to the air chambers 92, 96. When the solenoid 101 of solenoid valve 82 is in an energized condition, solenoid valve 82 supplies air pressure to the air chamber 92. When the solenoid 101 of solenoid valve 82 is not in an energized condition, solenoid valve 82 vents the air chamber 92 toward ambient pressure through the exhaust port 58 or maintains the air chamber 92 at ambient pressure as the volume changes due to motion of the pneumatic piston 80. When the solenoid 103 of solenoid valve 84 is in an energized condition, solenoid valve 84 supplies air pressure to the air chamber 96. When the solenoid 103 of solenoid valve 84 is not in an energized condition, solenoid valve 84 vents the air chamber 96 toward ambient pressure through the exhaust port 72.

As shown in FIG. 4, to open the jetting valve 10, an electric pulse signal 140 is supplied to the coil of the solenoid 101 of solenoid valve 82 at time t₁. While energized in this first state by the electric pulse signal 140, the mechanical valve 55 of solenoid valve 82 is switched so that air pressure can be supplied to the air chamber 92 at the pressure established by regulator 124. The pressurization of air chamber 92 generates a force that moves or lifts the drive pin 36 and pneumatic piston 80 in a first direction away from the fluid module 12. As described below, when this happens, the spring, or biasing element, 68 causes the valve element 14 to retract away from valve seat 52.. As the pneumatic piston 80 is lifted in the first direction, the solenoid 103 of solenoid valve 84 remains in an unenergized condition and the air chamber 96 is coupled with the exhaust port 72 of solenoid valve 84. In this second state, the solenoid valve 84 vents the air pressure from the air chamber 96 created by the motion of the pneumatic piston 80 in the first direction.

When the drive pin 36 has been raised by a desired distance, or for desired duration, an electric pulse signal 150 is supplied at time t₂ to the solenoid 103 of solenoid valve 84 to open the mechanical valve 69 of solenoid valve 84 and to supply compressed air from the air supply 93 to air chamber 96. The force applied by the pressurization of air chamber 96 to pneumatic piston 80 and the force of the compression spring 86 cooperate to cause the drive pin 36 to begin moving downwardly toward the fluid module 12. However, the pressurized air at the pressure established by regulator 124 remains in air chamber 92 because the solenoid 101 of solenoid valve 82 is still energized. At time t₃, the electric pulse signal 140 is discontinued to the solenoid 101 of solenoid valve 82. In the non-energized state, the mechanical valve 55 of solenoid valve 82 is switched to vent the air pressure from air chamber 92 through the exhaust port 58 and to return air chamber 92 to ambient pressure. This causes drive pin 36 to move more rapidly towards the fluid module 12 and impact the fluid module 12 to jet a droplet of material. At time t₄, the electric pulse signal 150 is discontinued to the solenoid 103 of solenoid valve 84. In the non-energized state of its solenoid 103, the mechanical valve 69 of solenoid valve 84 is switched to vent the air pressure from air chamber 96 through the exhaust port 72 and to return air chamber 96 to ambient pressure. With both chambers 92, 96 at ambient pressure, the spring 86 holds down piston 80 and drive pin 36 in Figure 2 to maintain the valve element 14 against valve seat 52 in the normally closed position.

The electric pulse signals 140, 150 are timed to be overlapping so that, over a portion but not all of each cycle, the air chambers 92, 96 are concurrently pressurized. An overlap period for the pressurization of the air chambers 92, 96 is determined by the temporal coincidence between the electric pulse signals 140, 150. The overlap period can be controlled by adjusting the onset time, t₁, and the end time t₃ for pulse 140 and by adjusting the onset time, t₂, and the end time, t₄, for pulse 150. The onset time, t₁, for pulse 140 will precede the onset time, t₂, for pulse 150. The end time, t₃, for pulse 140 will precede the end time, t₄, for pulse 150. The onset time, t₂, for pulse 150 is sequenced to occur between the onset time, t₁, for pulse 140 and the end time, t₃, for pulse 140. Similarly, the end time, t₃, for pulse 140 is sequenced to occur between onset time, t₂, for pulse 150 and the end time, t₄, for pulse 150. These timings, particularly the timing of t₂ and t₃, which are controlled by the controller 104, produce the overlap in the pulses 140, 150.

While not apparent in FIGS. 4 and 5, the pulses 140, 150 are idealized and are understood to have rise and fall times as understood by a person having ordinary skill in the art. In addition, the times t₁-t₄ represent either the moments that the pulses 140, 150 are dispatched from the controller 104 and almost instantaneously received by the solenoid valves 92, 94. The mechanical valve 55 of solenoid valve 82 and the mechanical valve 69 of solenoid valve 84 will each have a response time for actuation to switch the respective one of the flow paths 57, 71.

FIG. 4 shows an overlap period denoted as Overlap Time 1 for the electric pulse signals 140, 150, which is measured between time t₂ and time t₃, that is a comparatively long overlap time. Given the relatively lengthy duration of Overlap Time 1, a pressurized condition exists in the air chamber 96 over a relatively large fraction of the time that the pneumatic piston 80 is moving downwardly to close the jetting valve 10. The air pressure in air chamber 92 opposes the downward motion of the pneumatic piston 80 and, in turn, causes the drive pin 36 to move at a relatively slow velocity. Generally, the rate of motion of pneumatic piston 80 is proportional to the temporal overlap between the electric pulse signals 140, 150. The shorter the overlap, the faster the piston 80 will move downwardly in Figure 2, and the longer the overlap, the slower piston will move downwardly.

The controller 104 is operable to hold the first solenoid valve 82 in a first state for a first time period. The solenoid valve 82 is held in the first state, in which air pressure is supplied to air chamber 92, for a period of time approximately equal to the duration of the electric pulse signal 140. The duration of the electric pulse signal 140 and, hence, the first time period are defined by the time period between times t₁ and t₃. The controller 104 is operable to hold the second solenoid valve 84 in the first state, in which air pressure is supplied to air chamber 96, for a second time period approximately equal to the duration of the electric pulse signal 140. The duration of the electric pulse signal 150 and, hence, the second time period are defined by the time period between times t₂ and t₄.

The controller 104 maintains a predetermined overlap period between the first time period (i.e., the duration of electric pulse signal 140) and the second time period (i.e., the duration of electric pulse signal 150). The drive pin 36 moves towards the valve seat 52 during the second time period. The overlap period is used to control the speed of the drive pin 36 as the drive pin 36 is moved towards the valve seat 52 during the second time period. The movement of the drive pin 36 during the second time period causes the valve element 14 to move into contact with the valve seat 52 to jet a droplet of material.

In the preferred embodiment described herein, the movement of the drive pin 36 during the second time period causes the drive pin 36 to contact the fluid module 12. Specifically, the contact is with the wall 62 of the movable element 60 as described hereinabove. The contact of the drive pin 36 with the fluid module 12 causes the valve element 14 to move into contact with the valve seat 52 to jet a droplet of material.

For the next cycle of the jetting valve 10 shown in FIG. 4, pulse signals 142, 152 similar to pulse signals 140, 150 and with Overlap Time 1 are supplied to the solenoids 101, 103 of solenoid valves 82, 84. Successive cycles are generated by successive electrical pulse pairs (not shown) with the same Overlap Time 1 as pulse signals 140, 150 and pulse signals 142, 152 to sequentially jet droplets of material.

FIG. 5 shows an overlap period given by an Overlap Time 2 for the pulse signals 140, 150 between time t₂ and time t₃ that is shorter in duration than the overlap period given by Overlap Time 1 (FIG. 4). In FIG. 5, the drive pin 36 will move at a higher velocity than in FIG. 4 because the pneumatic piston 80 will move downwardly against a pressurized condition in the air chamber 92 for shorter period of time. This is because in FIG. 5, the air chamber 92 is vented more quickly toward atmospheric pressure after the solenoid 103 of solenoid valve 84 has been energized than is the case in FIG. 4.

Thus, the overlap time between the pulses powering the solenoid valves 82, 84 can be used to control the speed of the drive pin 36 and valve element 14. A shorter overlap period (e.g., Overlap Time 2) may be utilized for relatively thick materials that require the drive pin 36 to be moving faster to jet the material. For thinner materials, the drive pin 36 needs to be moved at a slower speed, so as not to cause splashing of the material when it is jetted, and thus a longer overlap period (e.g., Overlap Time 1) may be utilized.

Figure 6 shows two sample points to illustrate the correlation between overlap time and viscosity. The material for Point A is a viscosity of 12,500 centipoise (at 25° C) and for that material it has been empirically determined that an overlap time of 1 millisecond provides good jetting of droplets. The material for Point B is a higher viscosity material having a viscosity of 60,000 centipoise (at 25° C). For that material, it has been empirically determined that an overlap time of 0.25 milliseconds provides good jetting. This type of information, which may be obtained for numerous materials, may be stored in a lookup table that would be available via the user interface. Additionally, this data can be used to generate a line, a curve or mathematical formula that automatically produces an overlap time for a given viscosity value. This is described in more detail below.

Note that although viscosities of materials are typically given by manufacturers at 25° C which is approximately room temperature, it is common to heat materials to a jetting temperature to reduce their viscosity before they are jetted. Thus, if desired, the system may be set up to utilize viscosities at jetting temperatures rather than 25°C room temperature viscosities, with appropriate adjustments made.

### User Interface for Drive Pin Speed Control

Given this description of the invention, and how overlap time can be controlled, controller 104 may include a keyboard, mouse and display, for example, that allows the user to input information that can be used by the controller 104 to control the speed of movement of the pneumatic piston 80, and thereby, the speed at which the valve element 14 is moved by the movement of the piston 80 as valve element 14 contacts the valve seat 52 to jet a droplet of material.

For example, the user may input a viscosity value for the material to be jetted. In response to that input, a lookup table within the controller 104 may be used to correlate an empirically-determined overlap time value with the viscosity value. That overlap time value may then be used by controller 104 to control the solenoids 82, 84 to produce a drive pin velocity or speed that provides good jetting for the material. As an alternative to a look-up table and as mentioned above, if the empirical data follows a curve, curve fitting tools may be used to determine a mathematical equation that correlates overlap time with viscosity and that formula may be utilized by the controller to generate the overlap time that corresponds to the viscosity value input by the user.

As another example, controller 104 may utilize a control panel, or touch screen, with a series of buttons or pads representing a range of viscosity materials, such as a range for high viscosity values, a range for medium viscosity materials and a range for low viscosity materials. If the user will be jetting a material in the medium viscosity range, the user can push the medium viscosity button. In response to this input, the controller 104 selects the overlap time that has been empirically determined to produce good jetting with medium viscosity materials. The controller 104 would then use that overlap time value to control the solenoids 82, 84 to produce the desired drive pin speed.

As yet another example, controller 104 may include a database of different materials that are jetted by the user. Each material may typically be supplied by a jetting material manufacturer and given a product name by the manufacturer, such as Product A. In that instance, if the user is using Product A, the user may go to an appropriate screen in the interface provided by controller 104, and using a drop-down list, for example, select Product A. In response to that selection, controller 104 may use a lookup table to find the numerically determined overlap time value for that material and use that overlap time value to control the solenoids 82, 84 to achieve the desired drive pin speed for that material.

As still another example, controller 104 may include an interface with a slide bar. When the user moves the slide bar in one direction, the controller reduces the overlap time to speed up the drive pin velocity. When the user moves the slide bar in the opposite direction, the controller 104 increases the overlap time to speed up the drive pin velocity. During jetting tests, the user may use the slide bar to speed up and slow down the drive pin speed of the jetting valve and observe the results of the jetting tests. Based on those results, the operator may empirically determine which overlap time produces the best results for the material being jetted and use that overlap time in the manufacturing operation. The user may also build up its own look up table in this way by empirically determining an optimal overlap time for each material that the user jets in its manufacturing operation. In another variation, the user may use the high viscosity, medium viscosity and low viscosity buttons, or pads on a touch screen, to initially set the position of the slide bar. Then, if the material does not jet properly but instead accumulates on the nozzle, the user may adjust the sliding scale to reduce the overlap time and increase the drive pin speed until proper jetting is achieved. Conversely, if the initial position of the slide bar caused splattering of material to occur on the substrate, and/or the production of small satellite droplets of material, then the sidebar may be used to increase the overlap time and reduce drive pin speed until proper jetting is achieved. The overlap time reading for good jetting may then be recorded, stored in memory and used for the manufacturing operation.

In yet another embodiment, overlap time, and thereby drive pin speed, may be changed "on the fly" while the jetting valve is moved by a robot across a substrate to jet a droplet of material with one overlap time/ drive pin speed used at one location on the substrate and to jet a droplet of material with a different overlap time/drive pin speed used at a different location on the substrate to jet another droplet of material.

Give the above description of how this invention operates, a number of inventive systems and methods can be employed to practice these invention.

### Systems Having User Interface To Control Valve Speed Of A Pneumatic Jetting Device

In one system for jetting materials according to the invention, the jetting device has a pneumatic piston that causes movement of a valve element that contacts a valve seat to jet a droplet of material and the controller has a user interface that enables the user to vary the speed of the valve element.

In another system the jetting device has upper and lower piston chambers on opposite sides of the piston that are controlled by independent solenoid valves, and the speed of the valve element is controlled by the control of the solenoids.

In another system, the solenoids are controlled to provide a desired overlap time period during which compressed air is supplied to both the upper and lower piston chambers at the same time.

### Methods for Jetting From A Pneumatically Actuated Jetting Device Having A Valve Speed User Interface

In one method for jetting materials according to the invention, the jetting device has a pneumatically-driven piston that causes a valve element to move into contact with a valve seat to jet a droplet of material, and a user interface is provided that the user can use to input information that is used by the controller to vary the speed of the valve element.

In another method, the user input relates to the material that is to be jetted from the jetting device.

In another method, the user input relates to the viscosity of the material.

In another method, which does not form part of the present invention, the jetting device is pneumatically actuated and has a drive pin fixed to a piston that is reciprocated by compressed air supplied to chambers on opposite sides of the piston, wherein movement of the drive pin moves a valve element into contact with a valve seat in a fluid chamber to jet a droplet of material through a nozzle orifice that is in fluid communication with the fluid chamber, and wherein: the valve is first maintained in a closed position with the valve element forced against the valve seat; then at a time T₁ the chamber on one side of the piston is connected to a supply of compressed air to retract the piston, drive pin and valve element away from the valve seat and allow fluid material to flow into the valve seat; at a time T₂ that is after T₁, the chamber on the opposite side of the piston is connected to a supply of compressed air, to move the piston, drive pin and valve element towards the valve seat; at a time T₃ that is after T₂, the first chamber is disconnected from the supply of compressed to allow pressure in the first chamber to be vented; and at a time T₄ that is after T₃, the second chamber is disconnected from the supply of compressed air to allow pressure in the second chamber to be vented; wherein the time period between T₂ and T₃ comprises an overlap period during which both the first chamber and the second chamber are connected to a supply of compressed air; and wherein the duration of the overlap period is selected to control the velocity of the drive pin while it moves towards the valve seat.

In another method, a shorter duration overlap period is utilized to jet materials having a first viscosity and a longer duration overlap period is utilized to jet materials having a second viscosity, wherein said first viscosity is less than said second viscosity.

In another method, a user interface is provided that the user can use to input information to a controller and the controller utilizes the information input by the user to generate the overlap period that controls the drive pin velocity.

In another method, the user inputs information relating to the material and the controller utilizes the information input by the user to generate the overlap period that controls the drive pin velocity.

In another method, the user inputs information relating to the material viscosity and the controller utilizes the information input by the user to generate the overlap period that controls the drive pin velocity.

In another method, data correlating overlap period duration with material viscosity is stored and the controller utilizes the information input by the user and the stored data to generate the overlap period that controls the drive pin velocity.

In another method, a mathematical formula correlating information of the type input from the user at the user interface with overlap time period information is stored in the controller and that formula is utilized by the controller in response to the information input by the user to provide the desired overlap time period.

In another method, a slide bar is provided on a user interface that allows the user to reduce overlap time, and thereby, increase drive pin speed, or increase overlap time, and thereby reduce drive pin speed.

In another method, buttons, or touch pads, on a user interface are provided that correspond to material characteristics such as viscosity ranges. The user then uses the button or touch pad to select the range most appropriate for the material to be jetted and the controller retrieves from memory the overlap time that has been empirically determined to work best with that viscosity range and uses that overlap time to jet materials.

In another method, the user then uses the button or touch pad to select the range most appropriate for the material to be jetted and the controller retrieves from memory the overlap time that has been empirically determined to work best with that viscosity range and presets the slide bar to use that overlap time to jet materials. The user then uses the slide bar to hunt for a more optimal overlap time by speeding up and slowing down drive pin velocity and recording the drive pin speed/overlap time that produces the best jetting for the material. That drive pin speed/overlap time valve is then used in the manufacturing operation.

## Claims

1. A jetting valve (10) for use with a supply of fluid material and a supply (93) of air pressure, the jetting valve comprising:
a pneumatic actuator (16) having a pneumatic piston (80) and a drive pin (36) extending from the pneumatic piston (80), the drive pin (36) being moved by the pneumatic piston (80);
a housing (90) having a first chamber (92) and a second chamber (96), the pneumatic piston (80) enclosed between the first chamber (92) and the second chamber (96);
a first solenoid valve (82) connected to the supply (93) of air pressure, the first solenoid valve (82) having a first state in which air pressure is supplied to the first chamber (92) to apply a first force to the pneumatic piston (80) for moving the pneumatic piston (80) and drive pin (36) in a first direction, and the first solenoid valve (82) having a second state in which the first chamber (92) is vented to ambient pressure;
a second solenoid valve (84) connected to the supply (93) of air pressure, the second solenoid valve (84) having a first state in which air pressure is supplied to the second chamber (96) to apply a second force to the pneumatic piston (80) for moving the pneumatic piston (80) and drive pin (36) in a second direction, and the second solenoid valve (84) having a second state in which the second air chamber (96) is vented to ambient pressure;
a fluid chamber (38) enclosing a valve seat (52) and a valve element (14), the valve element (14) being movable to a position in contact with the valve seat (52);
a nozzle (28) having a flow passage and a dispense orifice, the flow passage being in fluid communication with the valve seat (52); and
a controller (104) configured to:
energise the first solenoid valve (82) to the first state at a first time (T1) for a first time period and maintain the second solenoid valve (84) in the second state,
energise the second solenoid valve (84) to the second state at a second time (T2) for a second time period while the first solenoid valve (82) is maintained in the first state, the second time (T2) following the first time (T1), such that the controller (104) maintains a predetermined overlap time period between said first time period and said second time period, the drive pin (36) moving towards the valve seat (52) during the overlap time period at a first controlled speed, and
de-energise the first solenoid valve (82) to the second state at a third time (T3) while the second solenoid valve (84) is maintained in the first state, the third time (T3) following the second time (T2), the drive pin (36) moving towards the valve seat (52) at a speed greater than the first controlled speed after the third time (T3) causing the valve element (14) to move into contact with the valve seat (52) to jet a droplet of the fluid material from the dispense orifice.

2. The jetting valve of claim 1 further comprising:
a fluid module (12) containing the fluid chamber (38),
wherein the movement of the drive pin (36) during the second time period causes the drive pin (36) to contact the fluid module (12), and the contact of the drive pin (36) with the fluid module (12) causes the valve element (14) to move into contact with the valve seat (52).

3. The jetting valve of claim 2 further comprising:
a resilient member (68) in the fluid module, the resilient member (68) configured to bias the valve element (14) away from the valve seat (52).

4. The jetting valve of any preceding claim wherein the housing (90) includes a spring (86) that exerts a spring bias on the pneumatic piston (80).

5. The jetting valve of claim 4 wherein the spring (86) is compressed when the pneumatic piston (80) is moved in the first direction by compressed air supplied to the first chamber (92), and the spring (86) is expanded when the pneumatic piston (80) is moved in the second direction by compressed air supplied to the second chamber (96).

6. A system for jetting a material, comprising the jetting valve (10) as claimed in any preceding claim, the controller (104) having a user interface (105), wherein the user interface (105) enables the user to vary the speed of the valve element (14),
wherein the first and second chambers (92, 96) on opposite sides of the piston (80) are controlled by the first and second solenoid valves (82, 84), and wherein the speed of the valve element (14) is controlled by the control of the first and second solenoid valves (82, 84) by the controller (104).

7. A method for jetting droplets of material onto a substrate with a system having the jetting system of claim 6, the method comprising the steps of:
providing a user interface that the user can use to vary the speed of the valve element;
accepting an input from the user at the user interface; and
using that input to control the speed of the valve element by controlling the first and second solenoid valves to provide a desired overlap time period during which compressed air is supplied to both the upper and lower piston chambers at the same time.

8. The method of claim 7, wherein the step of accepting the input from the user involves accepting input relating to a material that is to be jetted from the jetting system.

9. The method of claim 8, wherein the step of accepting the input from the user involves accepting input relating to the viscosity of the material.

10. The method in accordance with any one of claims 7 to 9, wherein the step of using the input to control the speed of the valve element involves using the input to control the speed that the valve element is moved into contact with the valve seat.

11. The method of claim 10, wherein the step of using the input to control the speed of the valve element involves storing information in a lookup table correlating information of the type input from the user at the user interface with overlap time period information, and accessing that information in response to the information input by the user to provide the desired overlap time period.

12. The method of claim 10, wherein the step of using the input to control the speed of the valve element involves storing a mathematical formula correlating information of the type input from the user at the user interface with overlap time period information and utilizing that formula in response to the information input by the user to provide the desired overlap time period.

## Patentansprüche

1. Ein Jet-Ventil (10) zur Verwendung mit einer Flüssigmaterialversorgung und einer Luftdruckversorgung (93), wobei das Jet-Ventil aufweist:
einen pneumatischen Aktuator (16) mit einem pneumatischen Kolben (80) und einem Antriebsstift (36), welcher sich von dem pneumatischen Kolben (80) erstreckt, wobei der Antriebsstift (36) durch den pneumatischen Kolben (80) bewegt wird;
ein Gehäuse (90) mit einer ersten Kammer (92) und einer zweiten Kammer (96), wobei der pneumatische Kolben (80) zwischen der ersten Kammer (92) und der zweiten Kammer (96) eingeschlossen ist;
ein erstes Magnetventil (82), das mit der Luftdruckversorgung (93) verbunden ist, wobei das erste Magnetventil (82) einen ersten Zustand aufweist, in dem der ersten Kammer (92) Luftdruck zugeführt wird, um eine erste Kraft auf den pneumatischen Kolben (80) auszuüben, um den pneumatischen Kolben (80) und den Antriebsstift (36) in eine erste Richtung zu bewegen, und das erste Magnetventil (82) ferner einen zweiten Zustand aufweist, in dem die erste Kammer (92) auf Umgebungsdruck entlüftet wird;
ein zweites Magnetventil (84), das mit der Luftdruckversorgung (93) verbunden ist, wobei das zweite Magnetventil (84) einen ersten Zustand aufweist, in dem der zweiten Kammer (96) Luftdruck zugeführt wird, um eine zweite Kraft auf den pneumatischen Kolben (80) auszuüben, um den pneumatischen Kolben (80) und den Antriebsstift (36) in eine zweite Richtung zu bewegen, und das zweite Magnetventil (84) ferner einen zweiten Zustand aufweist, in dem die zweite Luftkammer (96) auf Umgebungsdruck entlüftet wird;
eine Fluidkammer (38), die einen Ventilsitz (52) und ein Ventilelement (14) umschließt, wobei das Ventilelement (14) in eine Position in Kontakt mit dem Ventilsitz (52) bewegbar ist;
eine Düse (28), welche einen Strömungskanal und eine Abgabeöffnung aufweist, wobei der Strömungskanal in fluidleitender Verbindung mit dem Ventilsitz (52) steht; und
eine Steuerung (104), die so konfiguriert ist:
das erste Magnetventil (82) zu einer ersten Zeit (T1) für eine erste Zeitspanne in den ersten Zustand zu erregen und das zweite Magnetventil (84) in dem Zustand zu halten,
das zweite Magnetventil (84) zu einer zweiten Zeit (T2) für eine zweite Zeitspanne in den zweiten Zustand zu erregen, während das erste Magnetventil (82) in dem ersten Zustand gehalten wird, wobei die zweite Zeit (T2) auf die erste Zeit (T1) folgt, sodass die Steuerung (104) eine vorbestimmte Überlappungszeitspanne zwischen der ersten Zeitspanne und der zweiten Zeitspanne aufrechterhält, wobei sich der Antriebsstift (36) während der Überlappungszeitspanne mit einer ersten gesteuerten Geschwindigkeit auf den Ventilsitz (52) zu bewegt, und
das erste Magnetventil (82) zu einer dritten Zeit (T3) in den zweiten Zustand zu entregen, während das zweite Magnetventil (84) in den ersten Zustand gehalten wird, wobei die dritte Zeit (T3) der zweiten Zeit (T2) folgt, wobei sich der Antriebsstift (36) mit einer Geschwindigkeit, die größer ist als die erste gesteuerte Geschwindigkeit, auf den Ventilsitz (52) zu bewegt, und nach der dritten Zeit (T3) bewirkt, dass sich das Ventilelement (14) in Kontakt mit dem Ventilsitz (52) bewegt, um einen Tropfen des flüssigen Materials aus der Abgabeöffnung auszustoßen.

2. Das Jet-Ventil nach Anspruch 1, ferner aufweisend:
ein Fluidmodul (12), welches die Fluidkammer (38) enthält,
wobei die Bewegung des Antriebsstifts (36) während der zweiten Zeitspanne bewirkt, dass der Antriebsstift (36) das Fluidmodul (12) kontaktiert, und der Kontakt des Antriebsstiftes (36) mit dem Fluidmodul (12) bewirkt, dass sich das Ventilelement (14) in Kontakt mit dem Ventilsitz (52) bewegt.

3. Das Jet-Ventil nach Anspruch 2, ferner aufweisend:
ein elastisches Element (68) in den Fluidmodul, wobei das elastische Element (68) so konfiguriert ist, dass es das Ventilelement (14) von dem Ventilsitz (52) weg vorspannt.

4. Das Jet-Ventil nach einem der vorstehenden Ansprüche, wobei das Gehäuse (90) eine Feder (86) aufweist, die eine Federvorspannung auf den pneumatischen Kolben (80) ausübt.

5. Das Jet-Ventil nach Anspruch 4, wobei die Feder (86) zusammengedrückt wird, wenn der pneumatische Kolben (80) durch Druckluft, die der ersten Kammer (92) zugeführt wird, in die erste Richtung bewegt wird, und die Feder (86) expandiert wird, wenn der pneumatische Kolben (80) durch Druckluft, die der zweiten Kammer (96) zugeführt wird, in die zweite Richtung bewegt wird.

6. System zum Ausstoßen eines Materials, aufweisend das Jet-Ventil (10), wie in einem der vorstehenden Ansprüche beansprucht, wobei die Steuerung (104) eine Benutzerschnittstelle (105) aufweist, wobei es die Benutzerschnittstelle (105) dem Benutzer ermöglicht, die Geschwindigkeit des Ventilelements (14) zu variieren,
wobei die ersten und zweiten Kammern (92, 96) auf gegenüberliegenden Seiten des Kolbens (80) durch die ersten und zweiten Magnetventile (82, 84) gesteuert werden, und wobei die Geschwindigkeit des Ventilelements (14) durch die Steuerung der ersten und zweiten Magnetventile (82, 84) durch die Steuerung (104) gesteuert wird.

7. Ein Verfahren zum Ausstoßen von Tropfen eines Materials auf ein Substrat mit einem System, welches das System von Anspruch 6 aufweist, wobei das Verfahren die Schritte aufweist:
Bereitstellen einer Benutzerschnittstelle, mit welche der Benutzer die Geschwindigkeit des Ventilelements variieren kann;
Annahme einer Eingabe eines Benutzers an der Benutzerschnittstelle; und
Verwendung dieses Eingangs zur Steuerung der Geschwindigkeit des Ventilelements durch Steuerung des ersten und zweiten Magnetventils, um eine gewünschte Überlappungszeitspanne bereitzustellen, während der Druckluft gleichzeitig der oberen und unteren Kolbenkammer zugeführt wird.

8. Das Verfahren nach Anspruch 7, wobei der Schritt des Annehmens der Eingabe des Benutzers das Annehmen einer Eingabe bezüglich eines Materials, das aus dem Jet-System ausgestoßen werden soll, beinhaltet.

9. Das Verfahren nach Anspruch 8, wobei der Schritt des Annehmens der Eingabe des Benutzers das Annehmen einer Eingabe bezüglich der Viskosität des Materials beinhaltet.

10. Das Verfahren nach einem der Ansprüche 7 bis 9, wobei der Schritt der Verwendung des Eingangs zur Steuerung der Geschwindigkeit des Ventilelements die Verwendung des Eingangs zur Steuerung der Geschwindigkeit, mit der das Ventilelement in Kontakt mit dem Ventilsitz bewegt wird, beinhaltet.

11. Das Verfahren nach Anspruch 10, wobei der Schritt der Verwendung der Eingabe zur Steuerung der Geschwindigkeit des Ventilelements das Speichern von Informationen in einer Nachschlagetabelle, welche Informationen der Typ-Eingabe von dem Benutzer an der Benutzerschnittstelle mit Überlappungszeitspanneninformationen korreliert, und den Zugriff auf diese Informationen in Reaktion auf die Informationseingabe durch den Benutzer beinhaltet, um die gewünschte Überlappungszeitspanne bereitzustellen.

12. Das Verfahren nach Anspruch 10, wobei der Schritt des Verwendens der Eingabe zur Steuerung der Geschwindigkeit des Ventilelements das Speichern einer mathematischen Formel aufweist, die Informationen der Typ-Eingabe von dem Benutzer an der Benutzerschnittstelle mit Überlappungszeitspanneninformationen korreliert und diese Formel in Reaktion auf die von dem Benutzer eingegebenen Informationen verwendet, um die gewünschte Überlappungszeitperiode bereitzustellen.

## Revendications

1. Valve de jetting (10) destinée à être utilisée avec une alimentation de matériau fluide et une alimentation (93) de pression d'air, la valve de jetting comprenant :
un actionneur pneumatique (16) présentant un piston pneumatique (80) et un ergot d'entraînement (36) partant du piston pneumatique (80), l'ergot d'entraînement (36) étant déplacé par le piston pneumatique (80) ;
un logement (90) présentant une première chambre (92) et une seconde chambre (96), le piston pneumatique (80) étant enfermé entre la première chambre (92) et la seconde chambre (96);
une première électrovanne (82) connectée à l'alimentation (93) de pression d'air, la première électrovanne (82) ayant un premier état dans lequel une pression d'air est fournie à la première chambre (92) pour appliquer une première force sur le piston pneumatique (80) afin de déplacer le piston pneumatique (80) et l'ergot d'entraînement (36) dans un premier sens, et la première électrovanne (82) ayant un second état dans lequel la première chambre (92) est ventilée à la pression ambiante ;
une seconde électrovanne (84) connectée à l'alimentation (93) de pression d'air, la seconde électrovanne (84) ayant un premier état dans lequel une pression d'air est fournie à la seconde chambre (96) pour appliquer une seconde force au piston pneumatique (80) afin de déplacer le piston pneumatique (80) et l'ergot d'entraînement (36) dans un second sens, et la seconde électrovanne (84) ayant un second état dans lequel la seconde chambre à air (96) est ventilée à la pression ambiante ;
une chambre à fluide (38) enfermant un siège de soupape (52) et un élément de soupape (14), l'élément de soupape (14) étant déplaçable jusqu'à une position en contact avec le siège de soupape (52) ;
une buse (28) présentant un passage d'écoulement et un orifice de distribution, le passage d'écoulement étant en communication fluidique avec le siège de soupape (52) ; et
un contrôleur (104) configuré pour :
exciter la première électrovanne (82) dans le premier état à un premier temps (T1) pendant une première période de temps et maintenir la seconde électrovanne (84) dans le second état,
exciter la seconde électrovanne (84) dans le second état à un deuxième temps (T2) pendant une seconde période de temps pendant que la première électrovanne (82) est maintenue dans le premier état, le deuxième temps (T2) suivant le premier temps (T1), de telle sorte que le contrôleur (104) maintienne une période de temps de chevauchement prédéterminée entre ladite première période de temps et ladite seconde période de temps, l'ergot d'entraînement (36) se déplaçant vers le siège de soupape (52) durant la période de temps de chevauchement à une première vitesse régulée, et
désexciter la première électrovanne (82) dans le second état à un troisième temps (T3) pendant que la seconde électrovanne (84) est maintenue dans le premier état, le troisième temps (T3) suivant le deuxième temps (T2), l'ergot d'entraînement (36) se déplaçant vers le siège de soupape (52) à une vitesse supérieure à la première vitesse régulée après le troisième temps (T3) amenant l'élément de soupape (14) à venir en contact avec le siège de soupape (52) pour déposer une gouttelette du matériau fluide à partir de l'orifice de distribution.

2. Valve de jetting selon la revendication 1 comprenant en outre :
un module à fluide (12) contenant la chambre à fluide (38),
dans lequel le déplacement de l'ergot d'entraînement (36) durant la seconde période de temps amène l'ergot d'entraînement (36) à venir en contact avec le module à fluide (12), et le contact de l'ergot d'entraînement (36) avec le module à fluide (12) amène l'élément de soupape (14) à se déplacer et à venir en contact avec le siège de soupape (52).

3. Valve de jetting selon la revendication 2 comprenant en outre :
un élément élastique (68) dans le module à fluide, l'élément élastique (68) étant configuré pour solliciter l'élément de soupape (14) pour l'écarter du siège de soupape (52).

4. Valve de j etting selon n'importe quelle revendication précédente dans lequel le logement (90) comporte un ressort (86) qui exerce une sollicitation de ressort sur le piston pneumatique (80).

5. Valve de jetting selon la revendication 4 dans lequel le ressort (86) est compressé quand le piston pneumatique (80) est déplacé dans le premier sens par de l'air comprimé fourni dans la première chambre (92), et le ressort (86) est détendu quand le piston pneumatique (80) est déplacé dans le second sens par de l'air comprimé fourni à la seconde chambre (96).

6. Système de jetting d'un matériau, comprenant une valve de jetting (10) selon n'importe quelle revendication précédente, le contrôleur (104) présentant une interface utilisateur (105), l'interface utilisateur (105) permettant à l'utilisateur à modifier la vitesse de l'élément de soupape (14),
dans lequel les première et seconde chambres (92, 96) sur des côtés opposés du piston (80) sont commandées par les première et seconde électrovannes (82, 84), et dans lequel la vitesse de l'élément de soupape (14) est régulée par la commande des première et seconde électrovannes (82, 84) par le contrôleur (104).

7. Procédé de jetting de gouttelettes de matériau sur un substrat avec un système comportant le système de jetting selon la revendication 6, le procédé comprenant les étapes suivantes :
la fourniture d'une interface utilisateur que l'utilisateur peut utiliser pour modifier la vitesse de l'élément de soupape ;
l'acceptation d'une entrée depuis l'utilisateur au niveau de l'interface utilisateur ; et
l'utilisation de cette entrée pour réguler la vitesse de l'élément de soupape en commandant les première et seconde électrovannes pour fournir une période de temps de chevauchement souhaitée durant laquelle de l'air comprimé est fourni aux deux chambres à piston supérieure et inférieure en même temps.

8. Procédé selon la revendication 7, dans lequel l'étape d'acceptation de l'entrée depuis l'interface utilisateur accepte l'entrée relative un matériau devant être déposé par le système de j etting.

9. Procédé selon la revendication 8, dans lequel l'étape d'acceptation de l'entrée depuis l'utilisateur implique l'acceptation d'une entrée relative à la viscosité du matériau.

10. Procédé selon l'une quelconque des revendications 7 à 9, dans lequel l'étape d'utilisation de l'entrée pour réguler la vitesse de l'élément de soupape implique l'utilisation de l'entrée pour réguler la vitesse à laquelle l'élément de soupape est déplacé pour venir en contact avec le siège de soupape.

11. Procédé selon la revendication 10, dans lequel l'étape d'utilisation de l'entrée pour réguler la vitesse de l'élément de soupape implique la mémorisation d'informations dans une table de consultation mettant en corrélation des informations de l'entrée de type provenant de l'utilisateur au niveau de l'interface utilisateur avec des informations de période de temps de chevauchement, et l'accès à ces informations en réponse aux informations entrées par l'utilisateur pour fournir la période de temps de chevauchement souhaitée.

12. Procédé selon la revendication 10, dans lequel l'étape d'utilisation de l'entrée pour réguler la vitesse de l'élément de soupape implique la mémorisation d'une formule mathématique mettant en corrélation des informations de l'entrée de type provenant de l'utilisateur au niveau de l'interface utilisateur avec des informations de période de temps de chevauchement et l'utilisation de cette formule en réponse aux informations entrées par l'utilisateur pour fournir la période de temps de chevauchement souhaitée.
